Europäisches Patentamt

(19) European Patent Office

Office européen des brevets

(11) Publication number: 0 013 597
A1

(12) EUROPEAN PATENT APPLICATION

(21) Application number: 80300022.3

(22) Date of filing: 03.01.80

(51) Int. Cl.³: H 03 K 17/62
H 04 N 9/32

(30) Priority: 09.01.79 GB 7900803

(43) Date of publication of application:
23.07.80 Bulletin 80/15

(84) Designated Contracting States:
AT BE DE FR GB IT

(71) Applicant: RCA CORPORATION
30 Rockefeller Plaza
New York, NY 10020(US)

(72) Inventor: Hinn, Werner
Rietholzstrasse 38
CH-8125 Zollikerberg(CH)

(74) Representative: Smith, Thomas Ian Macdonald et al,
50 Curzon Street
London W1Y 8EU(GB)

(54) Signal switching app

(57) A signal path (from A to C) includes, as DC connected series elements, the base-emitter path of a PNP input emitter-follower transistor (40) and the base-emitter path of an NPN output emitter-follower transistor (50). The junction of the series elements is connected by the collector-emitter path of an NPN switching transistor (60) to a reference potential point (ground) and by a resistor (51) to a positive DC supply terminal. With the switching transistor cut off, the emitter-followers (40, 50) are biased into conduction to enable the signal path. With the switching transistor (60) rendered conducting under control of a switching signal (SW) the base-emitter paths of both emitter-followers are reverse biased with resultant disabling of the signal path. In a dual standard color TV receiver, a pair of such signal paths are subject to complementary control of respective switching transistors (120, 130) to effect alternation of the operating mode of the receiver between a SECAM-reception mode in which the SECAM chrominance component is transcoded into a quasi-PAL format and applied to the input terminal (A) of one (30, 40, 50) of the paths, and a PAL-reception mode in which the PAL chrominance component is supplied to the input terminal (B) of the other path (90, 100), the common output terminal (C) of the two paths leading to a PAL decoder operative for either mode.

FIG. 2

EP 0 013 597 A1

Croydon Printing Company Ltd

0013597

# SIGNAL SWITCHING APPARATUS

The present invention relates generally to switching apparatus, and particularly to novel switching circuitry, which may advantageously serve, for example, in implementation of video signal switching functions in a dual-standard color TV receiver.

In the European Patent Application published as No. 0003169, a dual-standard PAL/SECAM color TV receiver arrangement is disclosed wherein standard PAL decoder apparatus is utilized (a) to decode, in conventional manner, a PAL-encoded signal, when such a transmission is received, and (b) to decode a quasi-PAL signal, developed by a SECAM-PAL transcoder operating in the general manner described in U. K. Patent No. 1,358,551, when a SECAM transmission is received. By use of a suitable identification system, such as described, for example, in the European Application published as No. 0004445, the receiver may be automatically switched, in dependence on the SECAM or PAL nature of the transmission received, between (1) a SECAM-reception mode of operation, in which the PAL decoder apparatus receives as its input a quasi-PAL chrominance signal output of the SECAM-PAL transcoder, and (2) a PAL-reception mode of operation, in which the PAL decoder apparatus receives as its input PAL chrominance signals which bypass the transcoder and pass instead through an appropriate PAL chroma band-pass filter.

The present invention is directed to novel switching circuitry, convenient for realization in integrated circuit form, which may advantageously serve to effect the above-described switching of PAL-decoder input signals, with assurance of adequate prevention of crosstalk between the respective input signals.

In accordance with the principles of the present invention, a signal path includes, as DC connected series elements, the base-emitter path of an input emitter-follower transistor of a given conductivity type, and the base-emitter path of an output emitter-follower transistor of the opposite conductivity type. The junction of the series elements is connected via (1) a direct current conductive impedance, and (2) the collector-emitter path of a switching transistor of said opposite conductivity type, to opposite terminals of a DC potential supply. The poling of the supply is such that, upon cutoff of the switching transistor, the input and output emitter-followers are biased into conduction to enable the signal path, whereas a rendering of the switching transistor heavily conducting results in reverse biasing of the base-emitter paths of both emitter followers to disable the signal path. In the disabled state of the path, the presence of a pair of high impedance series elements (reverse-biased base-emitter paths) with a low impedance shunt element (conducting collector-emitter path) at the junction thereof, assures strong attenuation of signals applied to the signal path input.

In an illustrative application of the present invention to the switching of PAL-decoder input signals in a dual-standard PAL-SECAM receiver, a first signal path of the above-described type is interposed between the output of the transcoder and the PAL-decoder input, while a second signal path of the above-described type is interposed between the output of the transcoder-bypassing path and the PAL-decoder input. Complementary switching signals applied to the switching transistors of the respective signal paths alternatively: (a) enable the first signal path to establish SECAM-mode operation, while disabling the second signal path to isolate the PAL decoder input from the bypassing path; and (b) enable the second signal path to establish PAL-mode operation, while disabling the first signal path to isolate the PAL decoder input from the transcoder. In view of the above-noted strong attenuation of input signals effected by the disabled signal path, operation of the dual-standard receiver in either of its operating modes takes place without significant interference from the signal output of the non-selected signal source.

In the accompanying drawings:

FIGURE 1 provides a block diagram illustration of a portion of a dual-standard PAL-SECAM color TV receiver incorporating a signal switching arrangement embodying the principles of the present invention; and

FIGURE 2 illustrates schematically circuitry for advantageous realization of the switching arrangement of FIGURE 1 pursuant to a particular embodiment of the present invention.

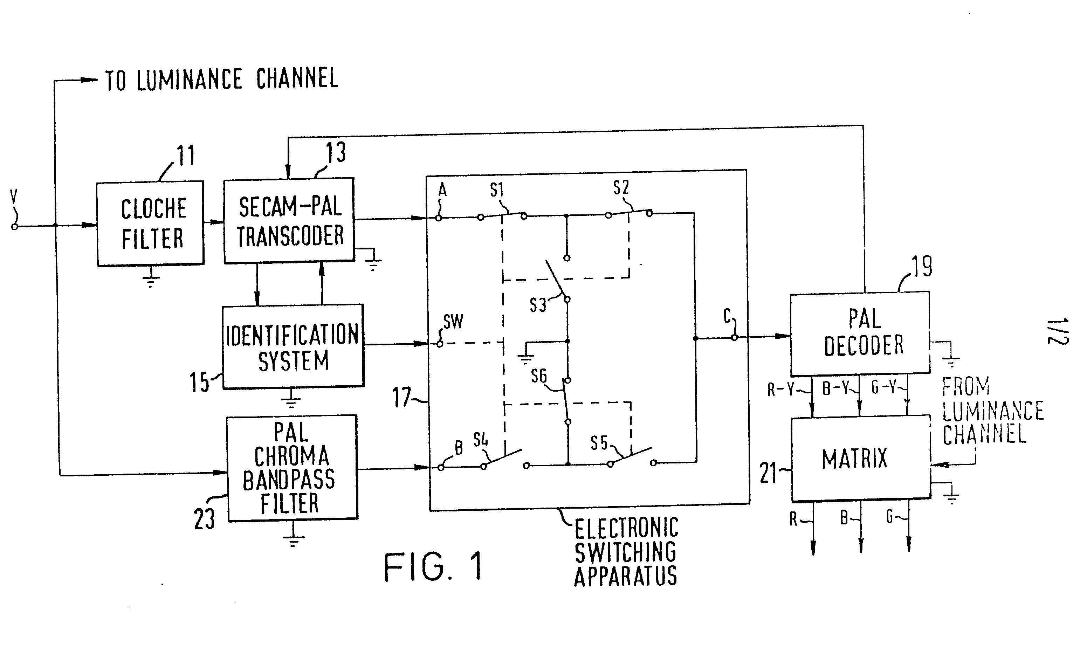

In FIGURE 1, composite video signals received by a dual-standard PAL/SECAM color TV receiver appear at an input terminal V, and are applied to the inputs of a cloche filter 11, a PAL chroma bandpass filter 23, and the receiver's luminance channel (not illustrated). Bandpass filter 23 has a passband encompassing the chrominance signal band associated with a PAL transmission. Filter 11 has a passband encompassing the chrominance signal band of a SECAM transmission, and is provided with a bandpass characteristic of a "cloche" or bell-shaped form, appropriately complementary to the characteristic employed for high frequency pre-emphasis of subcarrier side-bands in SECAM signal formation.

The output of filter 11 is supplied to a SECAM-PAL transcoder 13. The transcoder 13 is illustratively of the general type described in U.K. Patent No. 1,358,551, wherein the respective SECAM subcarriers are demodulated sequentially by a frequency discriminator, and the resultant color difference signals amplitude modulate in appropriate sequence respective phases of a subcarrier of PAL subcarrier frequency. The subcarrier wave input for transcoder 13 is derived from the reference oscillator of the receiver's PAL decoder 19.

For proper sequencing of operations in transcoder 13, an identification system 15, illustratively of the type described in the aforementioned European Application No. 0004445 is coupled to transcoder 13. In the transcoder 13, a flip-flop develops half line rate control waves for use in switching the center frequency tuning of the frequency discriminator employed for demodulating received SECAM signals. When the phasing of the flip-flop output is correct, the discriminator is provided with center frequency tuning appropriate for demodulation of the R-Y SECAM subcarrier (4.40625 MHz) during the image portion of a R-Y line interval of the SECAM signal, and tuning appropriate for demodulation of the B-Y modulated subcarrier (4.250 MHz) during the image portion of a B-Y line interval of the SECAM signal. Through the supplemental association of line rate, burst interval control waves, however, the timing of the changes in discriminator center frequency tuning is so controlled that during the lead-in bursts preceding the image portions of both R-Y and B-Y line intervals, the discriminator center frequency tuning is the same (e.g., tuned for a center frequency corresponding to the R-Y subcarrier). As a consequence of holding the same (R-Y subcarrier) center frequency tuning for all burst intervals, there appears, in the filtered output of the discriminator, pulses during alternate burst intervals which identify the successive occurrences of a particular (B-Y) line interval.

In the identification system 15, the filtered output of the transcoder's discriminator is applied to a pair of sample-and-hold circuits. Using respective half line rate control waves of mutually opposite phase derived from the flip-flop, and common line rate, burst interval gating pulses, for control of the sampling times of the respective sample-and-hold circuits, one sample-and-hold circuit effects sampling of the filtered discriminator output during the lead-in burst occurrence of alternate line intervals, while the other sample-and-hold circuit effects a sampling of the filtered discriminator output during the lead-in burst occurrence of the intervening line intervals. Comparison of the outputs of the two sample-and-hold circuits in a voltage comparator yields an output indicative of the correctness or incorrectness of the phasing flip-flop circuit. When the output is indicative of incorrect flip-flop phasing, the flip-flop is shut down and then allowed to restart, whereupon a new comparison is effected, with such a process repeated until correct flip-flop phasing is achieved.

The identification system 15 also develops, via such voltage comparison, a switching control signal for effecting automatic control of the receiver's operating mode, in dependence upon the SECAM or PAL nature of the received signals. This switching control signal output of identification system 15 is applied to a control terminal SW of electronic switching apparatus 17.

Electronic switching apparatus 17 includes: an array of six switch elements S1, S2, S3, S4, S5 and S6; a pair of signal input terminals A and B; and a signal output terminal C. The signal output of transcoder 13 is applied to signal input terminal A of the switching apparatus 17, while the output of the PAL chroma bandpass filter 23 is applied to signal input terminal B. The signal output terminal C of switching apparatus 17 is coupled to the input of PAL decoder 19.

The switch elements of switching apparatus 17 are illustrated as ganged for common control by the switching control signal applied to terminal SW, and these switch elements are illustrated in FIGURE 1 in the switching states that they assume when the switching control signal establishes a SECAM-reception mode of operation. In this mode of operation, it is desired that the PAL decoder 19 receive the quasi-PAL signal output of transcoder 13, while being isolated from the output of bandpass filter 23. In the illustrated switching states, switch elements S1, S2 and S6 are closed, and switch elements S3, S4 and S5 are opened. For the illustrated conditions, the transcoder output supplied to terminal A readily passes to output terminal C via closed switch elements S1 and S2 in series; diversion of such signals, via a shunt path interposed between the junction of switch elements S1 and S2 and a point of reference potential (e.g., ground), is substantially precluded by the open condition of switch element S3 in such shunt path.

Signal passage from input terminal B to output terminal C is obstructed by the presence of open switch elements S4 and S5 as the series elements in such path, and by the presence of a signal diverting shunt path presented by closed switch element S6 interposed between the junction of switch elements S4 and S5 and the reference potential point. Thus, delivery of the desired signal input (quasi-PAL signals produced by a SECAM-PAL transcoder 13) to decoder 19 is obtained, while significant interference from the undesired signal (output of PAL chroma bandpass filter 23) is precluded. The undesired signal is subject to strong attenuation by the divider formed by the high impedance series element represented by open switch S4 and by the low impedance shunt element represented by closed switch S6. The output of this divider is subject to further attenuation due to the subsequent high impedance series element represented by open switch S5.

The PAL decoder 19 operates upon the quasi-PAL signal, delivered to it by switching apparatus 17 under the illustrated conditions, in the manner described in the aforementioned U.K. Patent No. 1,358,551, to develop a set of color difference signals R-Y, B-Y and G-Y, which are supplied to matrix 21 for combination with a Y signal from the receiver's luminance channel. The output of the matrix 21 comprises set of color signals R, B and G which may be supplied to a conventional color kinescope for development of color images representative of the picture information contained in the received SECAM signals.

When the switching control signal applied to terminal SW is appropriate for establishment of a PAL-reception mode of operation for the receiver, the switching states of the respective switch elements of apparatus 17 are reversed from that illustrated in FIGURE 1; that is, switch elements S1, S2 and S6 are opened, and switch elements S3, S4 and S5 are closed. Under such conditions, signals from terminal B are passed to output terminal C via closed switch elements S4 and S5, while the shunt signal diverting path represented by switch S6 is open-circuited. Strong attenuation is provided for the output of transcoder 13 delivered to terminal A because of the high impedance state of series switch elements S1 and S2, and the low impedance state of the signal diverting path represented by closed switch S3. Under these conditions, the chrominance component of received signals of a PAL nature are passed by filter 23 and switching apparatus 17 to PAL decoder 19. Normal PAL decoding operations therein supply color difference information to matrix 21 for development of color signal outputs, which result in reproduction of color images representative of the picture information contained in the received PAL signal.

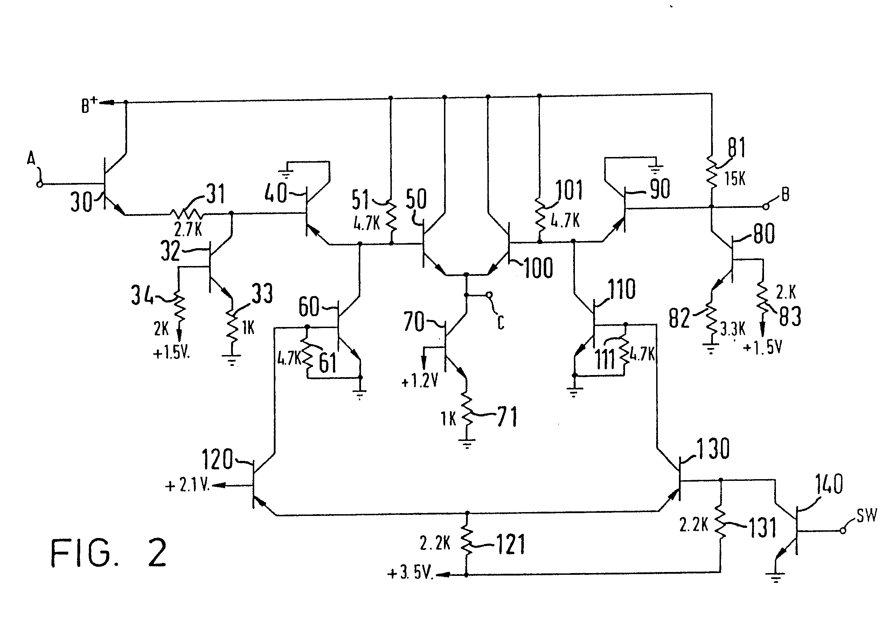

In FIGURE 2, circuitry for implementing the functions of the electronic switching apparatus 17 of the FIGURE 1 receiver is illustrated schematically. As illustrated therein, signals applied to input terminal A are delivered to the base of an NPN transistor 30. The emitter electrode of transistor 30 is connected by a resistor 31 to the base electrode of a PNP transistor 40. The collector electrodes of transistors 30 and 40 are connected to opposite terminals of a B+ supply of the receiver, with the collector of PNP transistor 40 connected to the negative terminal thereof (illustratively at ground potential), and the collector of NPN transistor 30 connected to the positive terminal thereof (illustratively at a +12 volt potential). An NPN transistor 32 has its collector electrode connected directly to the base electrode of transistor 40, its emitter electrode returned to ground via an emitter resistor 33, and its base electrode connected to a point of +1.5 volt bias potential via a resistor 34.

The emitter electrode of PNP transistor 40 is directly connected to the base of an NPN transistor 50. The collector electrode of transistor 50 is directly connected to the positive terminal of the B+ supply, while resistor 51 provides a direct current conductive path between the base electrode of transistor 50 and the positive terminal of the B+ supply. The emitter electrode of transistor 50 is directly connected to output terminal C. An NPN transistor 70 has its collector electrode directly connected to emitter electrode of transistor 50, its emitter electrode returned to ground via an emitter resistor 71, and its base electrode connected to a point of +1.2 volt bias potential.

Signals appearing at terminal B are delivered to the base electrode of a PNP transistor 90. The collector electrode of transistor 90 is directly connected to ground. A resistor 81 is connected between the base electrode of transistor 90 and the positive terminal of the B+ supply. An NPN transistor 80 has its collector electrode directly connected to the base electrode of transistor 90, its emitter electrode returned to ground via emitter resistor 82, and its base electrode connected by resistor 83 to a point of +1.5 volt bias potential.

The emitter electrode of PNP transistor 90 is directly connected to the base electrode of an NPN transistor 100. The collector electrode of transistor 100 is directly connected to the positive terminal of the B+ supply, while a resistor 101 provides a direct current conductive path between said positive terminal and the base electrode of transistor 100. The emitter electrode of transistor 100 is directly connected to output terminal C.

Switching control signals appearing at terminal SW are applied to the base of an NPN transistor 140. The emitter electrode of transistor 140 is grounded, while the collector electrode of transistor 140 is directly connected to the base of a PNP transistor 130. The emitter electrode of transistor 130 is connected via a resistor 121 to a point of +3.5 volt potential, while the base electrode of transistor 130 is connected to said point of +3.5 volt potential via a resistor 131.

The collector electrode of transistor 130 is directly connected to the base electrode of an NPN transistor 110. The emitter electrode of transistor 110 is grounded, and the base electrode is returned to ground via a resistor 111. The collector of transistor 110 is directly connected to the base of transistor 100.

A PNP transistor 120 has its emitter electrode directly connected to the emitter electrode of transistor 130, its base electrode connected to a point of +2.1 volt potential, and its collector directly connected to the base of an NPN transistor 60. The emitter electrode of transistor 60 is grounded, and the base electrode of transistor 60 is connected to ground via a resistor 61. The collector electrode of transistor 60 is directly connected to the base of transistor 50.

In the circuit arrangement of FIGURE 2, the structure of switching apparatus 17 of FIGURE 1 is implemented by transistors 40, 50, 60, 90, 100 and 110, with the base-emitter junction of transistor 40 serving as switch S1, the base-emitter junction of transistor 50 serving as switch S2, the collector-emitter path of transistor 60 serving as switch S3, the base-emitter junction of transistor 90 serving as switch S4, the base-emitter junction of transistor 100 serving as switch S5, and the collector-emitter path of transistor 110 serving as switch S6. Control of the switching state of these transistors is

effected by a differential amplifier formed by transistors 120 and 130 and driven by the switching signal input transistor 140.

Illustratively, the switching control signal applied from terminal SW to the base of transistor 140 goes high to render transistor 140 conducting when the SECAM-reception mode is to be established, and goes low to cut off transistor 140 when the PAL-reception mode is to be established. When transistor 140 conducts in the former instance, transistor 130 is rendered conducting to turn on transistor 110, bringing the base of transistor 100 and the emitter of transistor 90 close to the ground potential. Under these circumstances, transistor 120 and transistor 60 are cut off.

Emitter follower transistor 30, together with resistor 31 and the current source formed by transistor 32 and its emitter resistor 33, comprise a DC level shifter which supplies the quasi-PAL signal input from terminal A to the base of transistor 40 while biasing the base of transistor 40 at a potential intermediate the potentials at the opposite terminals of the B+ supply. Resistor 81 cooperates with the current source formed by transistor 80 and its emitter resistor 82 to likewise bias the base of transistor 90 (to which PAL input signals from terminal B are supplied) at a potential intermediate the potentials at the opposite terminals of the B+ supply. When the above-described switching conditions are established, i.e. cutoff of transistor 60, and conduction by transistor 110, the base-emitter paths of transistors 40 and 50 are forward biased by biasing current flowing via resistor 51. In contrast, the base-emitter paths of transistors 90 and 100 are reverse biased, with the emitter electrode of NPN transistor 100 driven to a potential driven more positive then its base electrode, and with the base electrode of PNP transistor 90 at a potential more positive then its emitter electrode, and the biasing current supplied by resistor 100 is diverted into the collector-emitter path of conducting transistor 110. Passage of signals from terminal A to terminal C takes place via the conducting base-emitter paths of transistors 40 and 50, while strong attenuation of input signals from terminal B takes place due to the high impedances presented by the series elements constituted by the reverse biased base-emitter paths of transistors 90 and 100, and the low impedance shunt path presented by the conduction transistor 110.

When the switching control signal at terminal SW goes low to cut off transistor 140, transistors 130 and 110 are cut off, and transistors 120 and 60 are driven into conduction to establish the PAL-reception mode. With transistor 110 cut off, the base-emitter paths of transistors 90 and 100 are forward biased by biasing current supplied via resistor 101. With the base of transistor 50 and the emitter of transistor 40 brought close to ground potential by the conduction of transistor 60, the base-emitter paths of transistors 40 and 50 are reverse biased, and the biasing current flowing in resistor 51 is diverted into the collector-emitter path of conducting transistor 60. Under these circumstances, input signals from terminal B pass to output terminal C via the conducting base-emitter paths of transistors 90 and 100, while input signals from terminal A are strongly attenuated, due to the presence of the high impedance series elements presented by the reverse biased base-emitter paths of transistors 40 and 50 and the low impedance shunt path presented by conducting transistor 60.

In the circuit arrangement of FIGURE 2, the base electrodes of the current source transistors 32 and 80 are biased from a common +1.5 volt supply. The respective couplings to this supply are effected via respective decoupling resistors 34 and 83. The decoupling resistors prevent undesired coupling between the two inputs across the parasitic capacitances existing between collector and base of the current source transistors.

0013597

## CLAIMS

1. Switching apparatus having a signal path which can be selectively enabled or disabled for signal transmission over said path, characterized in that the signal path includes, as DC connected series elements, the base-emitter path of an input emitter-follower transistor (40) of one conductivity type and the base-emitter path of an output emitter-follower transistor (50) of opposite conductivity type, that the junction of the series elements is connected via a direct current conductive impedance (51) and the collector-emitter path of a third, switching, transistor (60) of said opposite conductivity type, respectively, to opposite terminals (B+ and ground) of a DC potential supply, and that means (140, 120) are provided for selectively rendering said switching transistor (60) conductive or non-conductive the poling of said supply being such that with the switching transistor non-conductive the input and output emmitter-followers (40, 50) are biased into conduction to enable the signal path, whereas with the switching transistor conductive the base-emitter paths of both emitter-followers are reverse biased to disable the signal path.

2. Switching apparatus for use with a source of signals and a power supply establishing a difference in DC potential between first and second supply terminals, said switching apparatus alternatively permitting and precluding transfer of signals from said source to a signal output terminal, said switching apparatus being characterized by the combination of:

a first transistor (40) of a first conductivity type, having base, emitter and collector electrodes;

second and third transistors (50, 60) of a second conductivity type, each having base, emitter and collector electrodes;

means (30, 31) for applying signals from said source to the base electrode of said first transistor (40);

direct current conductive means coupling the emitter electrode of said first transistor (40) to the base electrode of said second transistor (50);

direct current conductive impedance means (70, 71) for returning said emitter electrode of said second transistor (50) to said second supply terminal (ground), said output terminal (C) being coupled to said emitter electrode of said second transistor;

direct current conductive means coupling the collector electrode of said first transistor (40) to said second supply terminal;

direct current conductive means coupling the collector electrode of said second transistor (50) to said first supply terminal (B+);

a direct current conductive impedance (51) connected between said first supply terminal (B+) and the base electrode of said second transistor (50);

means (30, 31, 32) for biasing the base electrode of said first transistor (40) at a potential intermediate the potentials at said first and second supply terminals;

direct current conductive means connecting the emitter-collector path of said third transistor (60) between said second supply terminal and the base electrode of said second transistor (50); and

switching control means (140, 120) coupled to the base electrode of said third transistor (60) for alternatively cutting off said third transistor or rendering it strongly conductive.

3. A switching system for selectively coupling two signal input terminals (A,B) alternatively to a common output terminal (C) characterized by two signal paths as set forth in claim 1 or claim 2 respectively connected between said input terminals and said output terminal and further characterised by means (140, 130, 120) for selectively rendering the third transistor (60) of one path alternatively conductive or non-conductive while rendering the third transistor (110) of the other path non-conductive or conductive respectively.

4. A switching system according to claim 3 characterised in that the means for selectively rendering the third transistors (60, 110) conductive and non-conductive comprises a pair of further transistors (120, 130) connected in differential amplifier configuration and responsive to a switching signal and having respective output connections coupled to the base electrodes of said third transistors for controlling their conductivity in complementary fashion.

5. A switching system according to claim 3 or 4 characterised by its use in a color television receiver operable in response to reception of composite color television signals inclusive of a chrominance component encoded in SECAM format, and to reception of composite color television signals inclusive of a chrominance component encoded in PAL format, said receiver including

0013597

means responsive to received signals in SECAM format for transcoding their chrominance component to a chrominance component of a quasi-PAL format, and means bypassing said transcoding means for the chrominance component of received signals in PAL format, said signal paths respectively coupling the outputs of said transcoding means and said bypassing means to the common output alternatively to a PAL decoder.

FIG. 1

FIG. 2

## EUROPEAN SEARCH REPORT

**European Patent Office**

Application number

EP 80 30 0022

| Category | DOCUMENTS CONSIDERED TO BE RELEVANT | | | CLASSIFICATION OF THE APPLICATION (Int. Cl |
|---|---|---|---|---|
| | Citation of document with indication, where appropriate, of relevant passages | | Relevant to claim | |
| X | US - A - 4 000 428 (HARSHBARGER)<br>* Column 2, line 19 to column 3, line 61 * | | 1-3 | H 03 K 17/62<br>H 04 N 9/32 |
| X | L'ONDE ELECTRIQUE, vol. 46, no. 475, October 1966, Paris FR<br>BERTHIER: "Fonctions de corrélation pour signaux acoustiques", pages 1067-1073<br>* Page 1070, right-hand column, line 22 to page 1071, right-hand column, line 12 * | | 1-4 | |
| D | GB - A - 1 358 551 (RCA)<br>* Page 3, lines 89 to 111 * | | 5 | |

**TECHNICAL FIELDS SEARCHED (Int.Cl )**

H 03 K 17/62
H 03 F 3/72
H 04 N 9/32
9/42
9/40

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 17-04-1980 | CRISTOL |

EPO Form 1503.1   06.78